# EUROPEAN PATENT SPECIFICATION

(11) **EP 2 168 934 B1**
(45) Date of publication and mention of the grant of the patent: **11.01.2012**
(21) Application number: 08777887.4
(22) Date of filing: 04.07.2008
(51) Int. Cl.: C04B 35/00, H01L 21/673, C30B 29/06

(54) **SINTERED SILICON WAFER**
GESINTERTER SILICIUM-WAFER
TRANCHE DE SILICIUM FRITTÉ

(30) Priority: 13.07.2007 JP 2007184756
(43) Date of publication of application: 31.03.2010
(73) Proprietor: JX Nippon Mining & Metals Corporation, Tokyo 100-8164 (JP)
(72) Inventor: SUZUKI, Ryo, Kitaibaraki-shi Ibaraki 319-1535 (JP); TAKAMURA, Hiroshi, Kitaibaraki-shi Ibaraki 319-1535 (JP)
(74) Representative: Hoarton, Lloyd Douglas Charles
(86) International application number: PCT/JP2008/062172
(87) International publication number: WO 2009/011233

(56) References cited:
- JP-A- 11 340 155
- JP-A- 2003 286 023
- JP-A- 2004 284 929
- JP-A- 2004 289 065

## Description

### TECHNICAL FIELD

The present invention relates to a sintered silicon wafer with superior mechanical properties.

### BACKGROUND ART

In the silicon semiconductor manufacturing process, a wafer prepared based on single crystal pulling method is primarily used. This single-crystal silicon wafer has increased in size with the times, and it is expected to become 400mm or larger in the near future. In addition, a so-called mechanical wafer for testing is now required in order to establish the apparatus and peripheral technology necessary for the semiconductor manufacturing process.
Generally speaking, since this kind of mechanical wafer is subject to a fairly high precision testing, it needs to possess properties that are similar to the mechanical properties of single-crystal silicon. Thus, although previously it would be used for testing, it appears to be a reality that the single-crystal silicon wafer was being used as is. However, since a single-crystal silicon wafer of 400mm or larger is extremely expensive, an inexpensive wafer having similar properties as single-crystal silicon is in demand.

Meanwhile, as a component of such semiconductor manufacturing equipment, a proposal has also been made for application of a sputtering target formed from a rectangular or disk-shaped silicon plate. The sputtering method is being used as a means for forming thin films, and there are several sputtering methods including the bipolar pulsed DC sputtering method, radio-frequency sputtering method, magnetron sputtering method and the like. Thin films of various electronic parts are being formed using the sputtering characteristics unique to the respective methods.
This sputtering method is a method that a substrate as the anode is placed vis-a-vis a target as the cathode, and an electrical field is generated by applying a high voltage between the foregoing substrate and target under an inert gas atmosphere; and is applying the principle that the ionized electrons and inert gas collide in the electrical field to form a plasma, the cations in the plasma collide with the target surface to hammer out the constituent atoms in the target, and the discharged atoms adhere to the opposite substrate surface so as to form a film.

A sintered compact of polycrystalline silicon is proposed for this kind of sputtering target, and the target of this sintered compact is required to be of considerable thickness and to be of a large-size rectangle or disk shape in order to improve the deposition efficiency. Moreover, a proposal has also been made for using this sintered compact of polycrystalline silicon as a board for supporting the single-crystal silicon wafer. Nevertheless, polycrystalline silicon entails significant problems in that the sinterability is inferior, and the obtained products have low density and low mechanical strength.
In light of the above, in order to improve the properties of the foregoing target of silicon sintered compact; proposed is a silicon sintered compact formed by compression-molding the silicon powder obtained by being heated within a temperature range of 1200°C or higher but lower than the melting point of silicon under reduced pressure to deoxidize and subsequently sintering the molded material, wherein the crystal grain size of the sintered compact is set to be 100µm or less (for instance, refer to Patent Document 1).
However, although the density will relatively increase and the strength will also increase if the thickness of the target manufactured as described above is thin, for example 5mm or less; the density will continue to be a low density (less than 99%) and the mechanical strength will also deteriorate if the thickness becomes any thicker. Thus, there is a problem in that it is not possible to manufacture a large-size rectangular or disk-shaped target.

In light of the foregoing circumstances, the present applicant has previously proposed a silicon sintered compact of which the average crystal grain size is 50µm or less and the relative density is 99% or more, and its production method (refer to Patent Document 2). Although this silicon sintered compact possesses numerous advantages including high density and high mechanical strength, further improvement in these properties is being demanded.
[Patent Document 1] Japanese Patent No. 3342898
[Patent Document 2] Japanese Patent No. 3819863

### DISCLOSURE OF THE INVENTION

The present invention was devised in view of the foregoing circumstances, and provides a sintered compact wafer having a fixed strength and similar mechanical properties as single-crystal silicon even in cases of sintered silicon wafer of a large-size disk shape.

In order to achieve the foregoing object, the present inventors discovered that it is possible to obtain a sintered silicon wafer with improved mechanical strength by devising the sintering conditions and adjusting the crystal grain size.
Based on the foregoing discovery, the present invention provides:
(1)A sintered silicon wafer, wherein the maximum crystal grain size is 20µm or less and the average crystal grain size is 1µm or more but not more than 10µm;
(2) The sintered silicon wafer according to the above (1); wherein, when a wafer surface is divided into any plural sections and the average grain size is measured for each section, the variation in the average grain size of each section is ±5µm or less; and
(3) The sintered silicon wafer according to the above (1) or (2), wherein the wafer has a diameter of 400mm or more and the following mechanical properties 1) to 3) measured by collecting a plurality of test samples from the sintered silicon wafer:
   1) the average deflecting strength based on a three-point bending test is 20kgf/mm² or more but not more than 50kgf/mm²;
   2) the average tensile strength is 5kgf/mm² or more but not more than 20kgf/mm²; and
   3) the average Vickers hardness is Hv 800 or more but not more than Hv 1200.

Accordingly, it is possible to provide a sintered compact wafer having significantly improved strength even in cases of sintered silicon wafer of a large-size disk shape, and provide a sintered silicon wafer having similar mechanical properties as single-crystal silicon used as a mechanical wafer. In addition, since the strength is high, superior characteristics are yielded such as being able to prevent the generation of cracks and chipping, easily being processed into complex shapes, considerably improving the yield rate, and reducing manufacturing costs.

### BEST MODE FOR CARRYING OUT THE INVENTION

The present invention provides a sintered silicon wafer in which the maximum crystal grain size is 20µm or less and the average crystal grain size is 1µm or more but not more than 10µm. Consequently, it is possible to make the average deflecting strength (bending strength) of the wafer based on the three-point bending test to be 20kgf/mm² or more but not more than 50kgf/mm² the average tensile strength to be 5kgf/mm² or more but not more than 20kgf/mm², and the average Vickers hardness to be Hv 800 or more but not more than Hv 1200 even with sintered silicon wafers having a diameter of 400mm or larger. These are conditions that also coincide with the mechanical properties of a single-crystal wafer.
The greatest weakness of a sintered silicon wafer is the deterioration in the deflecting strength (bending strength), and the present invention is able to overcome this weakness.

When improving the foregoing mechanical properties, the miniaturization of the crystal grain size is extremely important. With a sintered silicon wafer in which the maximum crystal grain size exceeds 20µm and the average crystal grain size is less than 1µm or exceeds 10µm, it is not possible to achieve the foregoing mechanical properties; namely, the average deflecting strength based on the three-point bending test being 20kgf/mm² to 50kgf/mm², the average tensile strength being 5kgf/mm² or more but not more than 20kgf/mm², and the average Vickers hardness being Hv 800 to Hv 1200.
It is important to adjust the variation in the crystal grain size of the sintered silicon wafer; specifically, when a wafer surface is divided into any plural sections and the average grain size is measured for each section, it is important that the variation in the average grain size of each section is ±5µm or less. This is intended to achieve the uniformity in the wafer structure, which is directly related to the uniformity in the foregoing mechanical properties, and is able to effectively prevent nicks or cracks.

Since this kind of silicon sintered compact wafer has high mechanical strength and superior workability, not only can it be used as a mechanical wafer (or dummy wafer), but it can also be used as various components such as a sputtering target or a holder for semiconductor manufacturing equipment.
Upon manufacturing components, superior effects are yielded in that it is possible to prevent the generation of cracks and chipping of the sintered silicon wafer, easily process the sintered silicon into complex shapes, considerably increase the yield rate, and reduce manufacturing costs.
Based on the above, the present invention provides a sintered silicon wafer having a diameter of 400mm or greater in which the average deflecting strength of the wafer based on the three-point bending test is 20kgf/mm² or more but not more than 50kgf/mm², the average tensile strength is 5kgf/mm² or more but not more than 20kgf/mm², and the average Vickers hardness is Hv 800 or more but not more than Hv 1200. Conventionally, a sintered silicon wafer having a diameter of 400mm or greater and comprising the foregoing properties has not existed.

As a method of producing a silicon sintered compact, for instance, silicon powder prepared by pulverizing coarse grains of high-purity silicon of 5N or higher in a jet mill is baked within a temperature range of 1100 to 1300°C, preferably less than 1200°C, under reduced pressure to deoxidize, subject to primary sintering by hot pressing, and then subject to HIP treatment within a temperature range of 1200 to 1420°C at a pressure of 1000 atmospheres or greater.
Here, by using high-purity silicon powder and adopting the foregoing deoxidation conditions based on the pulverization and baking of the powder, and the temperature condition and the pressurized condition for HIP treatment; the crystal grain size can be adjusted, and the sintering conditions are adjusted so that the maximum crystal grain size becomes 20µm or less and the average crystal grain size becomes 1µm or more but not more than 10µm. During the sintering process, it is particularly effective to use silicon powder having an average grain size of 10µm or less.

In addition, deoxidation is important, and sufficient deoxidation is required for obtaining a silicon sintered compact of fine crystals. The reason why the baking temperature was set to be within a range of 1000 to 1300°C, preferably less than 1200°C, is because the elimination of oxygen will be insufficient if the temperature is less than 1000°C.
Deoxidation will proceed at 1200°C or higher, but necking (phenomenon where powers adhere to each other) will increase, and, even if the necking is undone during the hot press, there are drawbacks in that there will be variations in the grain size distribution, and the working hours will become long. Thus, it is essential that the upper limit of the temperature is set to 1300°C.

In the HIP conditions, if the temperature is less than 1200°C and the pressure is less than 1000 atmospheres, similarly a high-density silicon sintered compact cannot be obtained, and if the temperature is 1420°C, it will exceed the melting point of Si. With respect to the retention time of the respective processes, it is preferable to perform baking for roughly 5 hours, hot pressing for roughly 10 hours, and the HIP treatment for roughly 3 hours. Prolonged HIP treatment is undesirable since the crystal grains will become coarse. With that said, however, these times may be changed as needed according to the processing conditions, and the present invention is not limited to the foregoing length of time.

### [Examples]

The present invention is now explained in detail with reference to the Examples. These Examples are merely for facilitating the understanding of this invention, and the present invention shall in no way be limited thereby. In other words, various modifications and other embodiments based on the technical spirit claimed in the claims shall be included in the present invention as a matter of course.

### (Example 1)

Silicon powder having an average grain size of 7µm prepared by pulverizing silicon coarse grains having a purity of 6N with a jet mill was subject to baking treatment under reduced pressure at a temperature of 1000°C for 5 hours to deoxidize.
Subsequently, hot press was performed by setting the temperature to 1200°C and simultaneously setting the surface pressure to 200kgf/cm², and this was thereafter subject to HIP at a temperature of 1200°C and an applied pressure of 1400 atmospheres to obtain a silicon sintered compact having a diameter of 400mm.
The crystal grain size can be arbitrarily adjusted by using fine high-purity silicon, selecting the baking (deoxidation) condition, and respectively selecting the HIP temperature and the applied pressure. The silicon sintered compact obtained thereby was ground into a silicon wafer.

The silicon sintered compact wafer of Example 1 had an average crystal grain size of 7µm and a maximum crystal grain size of 16µm. The mechanical strength of the sintered silicon wafer was measured. The measured mechanical strength is the average value of the five points arbitrarily sampled from the wafer.
Consequently, the average bending strength of the five sampled points was 26kgf/mm², the average tensile strength was 14kgf/mm², and the average Vickers hardness was Hv 1000. It satisfied the properties required as a mechanical wafer. Incidentally, the characteristic values were rounded off to the whole number. The results are shown in Table 1.
As described above, since the silicon sintered compact wafer possesses sufficient strength, cracks or chipping did not occur even when the diameter of the wafer was increased to 420mm, 440mm, 460mm, 480mm...
Incidentally, although silicon having a purity of 6N was used since the inclusion of impurities in the silicon sintered compact wafer is undesirable, there is no particular problem so as long as the purity level is 5N or higher. In addition, the mechanical properties were not affected so as long as the purity level was 5N or higher.

**[Table 1]**

| | Purity | Maximum grain size | Average grain size | Deflecting strength | Tensile strength | Vickers hardness |
|---|---|---|---|---|---|---|
| | | µm | µm | kgf/mm² | kgf/mm² | Hv |
| Example 1 | 5N | 16 | 7 | 26 | 14 | 1000 |
| Example 2 | 5N | 20 | 1 | 39 | 17 | 1120 |
| Example 3 | 5N | 20 | 10 | 21 | 12 | 830 |
| Example 4 | 5N | 15 | 5 | 33 | 15 | 1080 |
| Example 5 | 5N | 10 | 6 | 31 | 16 | 1060 |
| Example 6 | 6N | 18 | 8 | 22 | 14 | 910 |
| Example 7 | 6N | 15 | 7 | 27 | 14 | 1010 |

| | | | | | | |
|---|---|---|---|---|---|---|
| "Deflecting strength" shows an average bending strength of the five sampled points. | | | | | | |

### (Examples 2 to 7)

Fine silicon powders having a purity of 5N and 6N and an average grain size of 1µm to 10µm were, as with Example 1, baked within a temperature range of 1100 to 1300°C under reduced pressure to deoxidize, and subsequently hot pressed within a temperature range of 1200 to 1420°C at a surface pressure of 200kgf/cm² or greater, and the silicon obtained thereby was further subject to HIP treatment within a temperature range of 1200 to 1420°C at a pressure of 1000 atmospheres or higher so as to produce sintered silicon in which, as shown in Table 1, the maximum crystal grain size is 20µm or less and the average crystal grain size is within the range of 1µm to to 10µm.
The results are similarly shown in Table 1. As shown in Table 1, the average deflecting strength was 21 to 39kgf/mm² the average tensile strength was 12 to 17kgf/mm², and the average Vickers hardness was Hv 830 to Hv 1120. In all cases, the average deflecting strength based on the three-point bending test was 20kgf/mm² or more but not more than 50kgf/mm², the average tensile strength was 5kgf/mm² or more but not more than 20kgf/mm², and the average Vickers hardness was Hv 800 or more but not more than Hv 1200. These possessed the mechanical properties of the present invention and could be used as a mechanical wafer.

### (Examples 8 to 10)

Next, based on representative Example 1 of the present invention, the variation in the average grain size of each section was observed when the silicon wafer surface was divided into any plural sections and the average grain size was measured for each section. The results are shown in Table 2.
According to the observation, a sintered silicon wafer in which the variation was ±5µm or less had an average deflecting strength of 25 to 26kgf/mm², an average tensile strength of 13 to 14kgf/mm², and an average Vickers hardness of Hv 970 to Hv 1000, and it is evident that the smaller the variation, the smaller the differences based on location and the better the mechanical properties. Accordingly, it is desirable to suppress the foregoing variation to ±5µm or less in order to stabilize the mechanical properties and improve the quality of the silicon wafer.
Nevertheless, it should be understood that the range of this variation will not cause any significant problem so as long as the maximum crystal grain size is 20µm or less and the average crystal grain size is within a range of µm or more but not more than 10µm in the present invention

**[Table 2]**

| | Purity | Maximum grain size | Average grain size | Deflecting strength | Tensile strength | Vickers hardness | Variation |
|---|---|---|---|---|---|---|---|
| | | µm | µm | kgf/mm² | kgf/mm² | Hv | µm |
| Example 8 | 5N | 16 | 7 | 26 | 14 | 1000 | 1 |
| Example 9 | 5N | 16 | 7 | 25 | 14 | 980 | 3 |
| Example 10 | 5N | 16 | 7 | 25 | 13 | 970 | -4 |

| | | | | | | | |
|---|---|---|---|---|---|---|---|
| "Deflecting strength" shows an average bending strength of the five sampled points. Variation" shows a variation in the average grain size. | | | | | | | |

### (Comparative Example 1)

A sintered silicon wafer having an average crystal grain size of 12µm and a maximum crystal grain size of 25µm was prepared by using silicon powder having a purity of 5N and an average grain size of 10µm, and respectively selecting the baking (deoxidation) condition, HIP temperature and applied pressure. As with Example 1, the mechanical strength was measured. The results are shown in Table 3. The measurement value of the mechanical strength is an average value of the five sampled points.
As shown in Table 2, the deflecting strength (bending strength) was 16kgf/mm², the tensile strength was 10kgf/mm², and the Vickers hardness was Hv 790. It did not satisfy the bending strength and the Vickers hardness required as a mechanical wafer. This is considered to be because it did not satisfy the conditions of the present invention; specifically, the maximum crystal grain size being 20µm or less and the average grain size being 1 to 10µm.

**[Table 3]**

| | Purity | Maximum grain size | Average grain size | Deflecting strength | Tensile strength | Vickers hardness |
|---|---|---|---|---|---|---|
| | | µm | µm | kgf/mm² | kgf/mm² | Hv |
| Comparative Example 1 | 5N | 25 | 12 | 16 | 10 | 790 |
| Comparative Example 2 | 5N | 8mm | 2mm | 8 | 5 | 780 |
| Comparative Example 3 | 5N | 22 | 11 | 18 | 11 | 820 |
| Comparative Example 4 | 5N | 20 | 15 | 12 | 8 | 760 |
| Comparative Example 5 | 5N | 25 | 10 | 19 | 11 | 820 |
| Comparative Example 6 | 6N | 22 | 16 | 12 | 7 | 720 |
| Comparative Example 7 | 6N | 12 | <1 | 42 | 21 | 1250 |

| | | | | | | |
|---|---|---|---|---|---|---|
| "Deflecting strength" shows an average bending strength of the five sampled points. The grain sizes in Comparative Example 2 are shown in units of "mm". | | | | | | |

### (Comparative Example 2)

Secondly, a silicon ingot having a maximum crystal grain size of 8mm and an average crystal grain size of 2mm was prepared with the melting method, and this was cut out to obtain a silicon wafer. The mechanical strength of this cast silicon wafer was measured as with Example 1. The results are shown in Table 3. The measurement value of the mechanical strength is an average value of the five sampled points.
As shown in Table 3, the average deflecting strength was 8kgf/mm², the average tensile strength was 5kgf/mm², and the average Vickers hardness was Hv 780. The deterioration in the average deflecting strength and the average tensile strength was considerable, and it did not satisfy the mechanical properties required as a mechanical wafer. The deterioration in properties is considered to be a result of the coarsening of the crystal grain size.

### (Comparative Examples 3 to 7)

Sintered silicon wafers having the average crystal grain size and maximum crystal grain size shown in Table 2 were prepared by using silicon having a purity of 5N and respectively selecting the baking (deoxidation) condition, HIP temperature and applied pressure. As with Example 1, the mechanical strength was measured. The results are shown in Table 3. The measurement value of the mechanical strength is an average value of the five sampled points.
As shown in Table 3, with Comparative Examples 3 to 6, the average deflecting strength was 12 to 19kgf/mm², the average tensile strength was 7 to 11 kgf/mm², and the average Vickers hardness was Hv 720 to Hv 820. These did not satisfy the bending strength and the Vickers hardness required as a mechanical wafer.
Meanwhile, with Comparative Example 7, the tensile strength and the Vickers hardness became greater than a single-crystal silicon wafer, and there was a problem in that the mechanical properties were no longer similar to those required as a mechanical wafer. Thus, the sintered silicon wafer of Comparative Example 7 was also inappropriate. This is considered to be because these did not satisfy the conditions of the present invention; specifically, the maximum crystal grain size being 20µm or less and the average grain size being 1 to 10µm.

### INDUSTRIAL APPLICABILITY

The present invention is able to obtain a sintered compact wafer having significantly improved strength and similar mechanical properties as single-crystal silicon even in cases of sintered silicon wafer of a large-size disk shape, and this is effective as a mechanical wafer. In addition, since this silicon sintered compact wafer has high mechanical strength, it can also be used as a sputtering target or various components of semiconductor manufacturing equipment.

## Claims

1. A sintered silicon wafer, wherein the maximum crystal grain size is 20µm or less and the average crystal grain size is 1µm or more but not more than 10µm.

2. The sintered silicon wafer according to claim 1; wherein, when a wafer surface is divided into any plural sections and the average grain size is measured for each section, the variation in the average grain size of each section is ±5µm or less.

3. The sintered silicon wafer according to claim 1 or claim 2, wherein the wafer has a diameter of 400mm or more and the following mechanical properties (1) to (3) measured by collecting a plurality of test samples from the sintered silicon wafer:
(1) the average deflecting strength based on a three-point bending test is 20kgf/mm² or more but not more than 50kgf/mm²;
(2) the average tensile strength is 5kgf/mm² or more but not more than 20kgf/mm²; and
(3) the average Vickers hardness is Hv 800 or more but not more than Hv 1200.

## Patentansprüche

1. Gesinterter Siliciumwafer, wobei die maximale Kristallkorngröße 20 µm oder weniger beträgt und die durchschnittliche Kristallkorngröße 1 µm oder mehr, aber nicht mehr als 10 µm beträgt.

2. Gesinterter Siliciumwafer nach Anspruch 1, wobei, wenn eine Waferoberfläche in beliebige mehrere Abschnitte unterteilt und die durchschnittliche Korngröße für jeden Abschnitt gemessen wird, die Schwankung der durchschnittlichen Korngröße jedes Abschnitts ±5 µm oder weniger beträgt.

3. Gesinterter Siliciumwafer nach Anspruch 1 oder Anspruch 2, wobei der Wafer einen Durchmesser von 400 mm oder mehr sowie die folgenden mechanischen Eigenschaften (1) bis (3) hat, welche gemessen werden, indem mehrere Testproben von dem gesinterten Siliciumwafer gesammelt werden:
(1) die durchschnittliche Beulfestigkeit auf der Grundlage eines Dreipunkt-Biegetests beträgt 20 kgf/mm² oder mehr, aber nicht mehr als 50 kgf/mm²;
(2) die durchschnittliche Zugfestigkeit beträgt 5 kgf/mm² oder mehr, aber nicht mehr als 20 kgf/mm²; und
(3) die durchschnittliche Vickers-Härte beträgt Hv 800 oder mehr, aber nicht mehr als Hv 1200.

## Revendications

1. Une tranche de silicium fritté, dans laquelle la grosseur maximale des grains de cristaux est de 20 µm ou moins et la grosseur moyenne des grains de cristaux est de 1 µm ou plus, mais pas plus de 10 µm.

2. La tranche de silicium fritté de la revendication 1, dans laquelle, lorsqu'une surface de la tranche est divisée en plusieurs sections et que la grosseur moyenne des grains est mesurée pour chaque section, la variation de la grosseur moyenne des grains de chaque section est de ±5 µm ou moins.

3. La tranche de silicium fritté de la revendication 1 ou 2, dans laquelle la tranche possède un diamètre de 400 mm ou plus et les propriétés mécaniques (1) à (3) suivantes, mesurées par le prélèvement de plusieurs échantillons sur la tranche de silicium fritté :
(1) la résistance moyenne à la déformation selon un essai de flexion en trois points est de 20 kgf/mm² ou plus, mais pas plus de 50 kgf/mm² ;
(2) la résistance moyenne à la traction est de 5 kgf/mm² ou plus, mais pas plus de 20 kgf/mm² ; et
(3) la dureté Vickers moyenne est de 800 Hv ou plus, mais pas plus de 1 200 Hv.
